(19) Europäisches Patentamt
European Patent Office
Office européen des brevets

(11) **EP 4 665 124 A1**

(12) **EUROPEAN PATENT APPLICATION**
published in accordance with Art. 153(4) EPC

(43) Date of publication:
**17.12.2025 Bulletin 2025/51**

(21) Application number: **24921206.9**

(22) Date of filing: **08.05.2024**

(51) International Patent Classification (IPC):
**H10K 30/88** (2023.01)     **H10K 30/40** (2023.01)
**H10K 30/50** (2023.01)     **H10K 71/00** (2023.01)

(86) International application number:
**PCT/CN2024/091701**

(87) International publication number:
**WO 2025/161163 (07.08.2025 Gazette 2025/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.01.2024   CN 202410138459**

(71) Applicant: **Trina Solar Co., Ltd
Changzhou, Jiangsu 213031 (CN)**

(72) Inventors:
• **LI, Hongjiang**
  **hangzhou, Jiangsu 213031 (CN)**
• **YI, Zongjin**
  **hangzhou, Jiangsu 213031 (CN)**
• **XIA, Rui**
  **hangzhou, Jiangsu 213031 (CN)**
• **YU, Danni**
  **hangzhou, Jiangsu 213031 (CN)**
• **ZHANG, Xueling**
  **hangzhou, Jiangsu 213031 (CN)**
• **LI, Wenqiang**
  **hangzhou, Jiangsu 213031 (CN)**
• **DAI, Xiafen**
  **hangzhou, Jiangsu 213031 (CN)**
• **XU, Rui**
  **hangzhou, Jiangsu 213031 (CN)**

(74) Representative: **Arnold & Siedsma
Bezuidenhoutseweg 57
2594 AC The Hague (NL)**

(54)     **SOLAR CELL AND PREPARATION METHOD THEREFOR**

(57)     A solar cell includes a first electrode, a second electrode, a perovskite layer, a first interface passivation layer, and a second interface passivation layer. The perovskite layer is disposed between the first electrode and the second electrode. The first interface passivation layer is disposed between the perovskite layer and the first electrode. The second interface passivation layer is disposed between the perovskite layer and the second electrode. Materials of the first interface passivation layer and the second interface passivation layer each include an inorganic material.

FIG. 1

**Description**

RELATED APPLICATIONS

This application claims priority to Chinese patent application No. 202410138459.1, entitled "SOLAR CELL AND PREPARATION METHOD THEREOF" filed on January 31, 2024, the content of which is hereby incorporated by reference in its entirety.

TECHNICAL FIELD

This application relates to the technical field of solar cells, and in particular, to a solar cell and a preparation method thereof.

BACKGROUND

Perovskite materials are suitable candidates for forming light-absorbing layers in solar cells due to their excellent optoelectronic characteristics and cost-effectiveness. Compared with the bulk phase of the perovskite layer, the interface of the perovskite layer exhibits a higher density of defects. These interface defects in the perovskite layer increase non-radiative recombination in solar cells, leading to a decline in solar cell performance. In addition, the interface defects in the perovskite layer are a major cause of solar cell failure under operational conditions.

SUMMARY

According to various embodiments of the present application, a solar cell and a preparation method thereof are provided.

In a first aspect, a solar cell is provided, including:

a first electrode and a second electrode;
a perovskite layer disposed between the first electrode and the second electrode;
a first interface passivation layer disposed between the perovskite layer and the first electrode; and
a second interface passivation layer disposed between the perovskite layer and the second electrode;
wherein materials of the first interface passivation layer and the second interface passivation layer each include an inorganic material.

Optionally, the material of the first interface passivation layer includes one or more of aluminum oxide, silicon oxide, or magnesium oxide.

Optionally, the material of the second interface passivation layer includes one or more of aluminum oxide, silicon oxide, or magnesium oxide.

Optionally, a thickness of the first interface passivation layer is in a range from about 0.1 nm to about 50 nm.

Optionally, a thickness of the second interface passivation layer is in a range from about 0.1 nm to about 50 nm.

Optionally, the first interface passivation layer and the second interface passivation layer each completely cover the perovskite layer.

Optionally, the solar cell further includes an electron transport layer, and the electron transport layer is disposed between the second electrode and the second interface passivation layer.

Optionally, a material of the electron transport layer includes two or more of fullerene, a derivative of fullerene, graphene, or carbon nanotubes.

Optionally, a thickness of the electron transport layer is in a range from about 0.1 nm to about 100 nm.

Optionally, the solar cell further includes a substrate layer, and the substrate layer is disposed on a surface of the first electrode facing away from the perovskite layer;

the electron transport layer is disposed on a surface of the second interface passivation layer facing away from the perovskite layer;
a material of the electron transport layer includes one or more of zinc oxide, titanium oxide, tin oxide, or niobium oxide.

Optionally, a thickness of the electron transport layer is in a range from about 1 nm to about 100 nm.

Optionally, the solar cell further includes a hole transport layer, and the hole transport layer is disposed between the first electrode and the first interface passivation layer.

Optionally, the hole transport layer is disposed on a surface of the first interface passivation layer facing away from the perovskite layer;

the solar cell further includes a substrate layer and a dense barrier layer, the dense barrier layer is disposed between the hole transport layer and the first electrode;

the substrate layer is disposed on a surface of the first electrode facing away from the perovskite layer;

the dense barrier layer is configured to prevent contact between the perovskite layer and the first electrode while allowing holes to be transported between the first electrode and the hole transport layer.

Optionally, a material of the dense barrier layer includes one or more of aluminum oxide, silicon oxide, or magnesium oxide.

Optionally, a thickness of the dense barrier layer is in a range from about 0.1 nm to about 5 nm.

Optionally, the solar cell includes a first cell and a second cell stacked on the first cell, wherein the first cell includes the perovskite layer, the first interface passivation layer, and the second interface passivation layer, and the second cell is any one of a perovskite cell, a silicon-based solar cell, a copper indium gallium selenide solar cell, or an organic thin-film solar cell.

In a second aspect, a method for preparing a solar cell is provided, including:

forming a first electrode on a substrate layer;

sequentially forming a first interface passivation layer, a perovskite layer, a second interface passivation layer, and a second electrode on a side of the first electrode facing away from the substrate layer; wherein the perovskite layer is formed between the first electrode and the second electrode, the first interface passivation layer is formed between the first electrode and the perovskite layer, the second interface passivation layer is formed between the second electrode and the perovskite layer, and a material of the first interface passivation layer and a material of the second interface passivation layer each include an inorganic material.

Optionally, the first interface passivation layer and the second interface passivation layer are independently deposited using one of the following methods:

atomic layer deposition, evaporation deposition, magnetron sputtering, or plasma-enhanced chemical vapor deposition.

Optionally, the solar cell further includes an electron transport layer; the method further includes:

before forming the second electrode on the second interface passivation layer, forming the electron transport layer on a surface of the second interface passivation layer facing away from the perovskite layer through evaporation deposition, wherein a material of the electron transport layer includes two or more of fullerene, a derivative of fullerene, graphene, or carbon nanotubes.

Optionally, the evaporation deposition includes at least one of thermal evaporation, electron beam evaporation, or close-space sublimation.

Optionally, the electron transport layer is formed by co-evaporation of a plurality of sources; or

the electron transport layer is formed by evaporation of a single source of physically mixed materials.

Optionally, the solar cell further includes an electron transport layer; the method further includes:

before forming the second electrode on the second interface passivation layer, depositing the electron transport layer on a surface of the second interface passivation layer facing away from the perovskite layer using one of the following methods:

atomic layer deposition, reactive plasma deposition, magnetron sputtering, slot-die coating, blade coating, spray coating, or inkjet printing;

wherein a material of the electron transport layer includes one or more of zinc oxide, titanium oxide, tin oxide, or niobium oxide.

Optionally, the solar cell further includes a hole transport layer and a dense barrier layer; the method further includes:

before forming the first interface passivation layer on the first electrode, sequentially forming the dense barrier layer and the hole transport layer on the first electrode, wherein the dense barrier layer is configured to prevent contact between the perovskite layer and the first electrode while allowing holes to be transported between the first electrode and the hole transport layer.

In a third aspect, a solar cell is provided, including:

a first electrode and a second electrode;

a perovskite layer disposed between the first electrode and the second electrode;

a hole transport layer disposed between the perovskite layer and the first electrode;

a dense barrier layer disposed between the first electrode and the perovskite layer, the dense barrier layer being configured to prevent contact between the perovskite layer and the first electrode while allowing holes to be transported between the first electrode and the hole transport layer.

Optionally, a material of the dense barrier layer includes one or more of aluminum oxide, silicon oxide, or magnesium oxide.

Optionally, a thickness of the dense barrier layer is in a range from about 0.1 nm to about 5 nm.

In a fourth aspect, a method for preparing a solar cell is provided, including:

forming a first electrode on a substrate layer;

sequentially forming a dense barrier layer, a hole transport layer, a perovskite layer, and a second electrode on a side of the first electrode facing away from the substrate layer;

wherein the dense barrier layer is configured to prevent contact between the perovskite layer and the first electrode while allowing holes to be transported between the first electrode and the hole transport layer.

Details of one or more embodiments of the present application are set forth in the accompanying drawings and description below. Other features, objects, and advantages of the present application will become apparent from the description, drawings, and claims.

BRIEF DESCRIPTION OF THE DRAWINGS

To illustrate the technical solutions in the embodiments of the present application or in conventional art more clearly, the drawings used in the embodiments or in conventional art will be described briefly. Apparently, the following described drawings are merely for the embodiments of the present application, and other drawings can be derived by those of ordinary skill in the art according to the disclosed drawings without any creative effort.

FIG. 1 is a schematic structural cross-sectional view of a solar cell according to an embodiment of the present application.

FIG. 2 is a schematic structural cross-sectional view of another solar cell according to an embodiment of the present application.

FIG. 3 is a schematic structural cross-sectional view of another solar cell according to an embodiment of the present application.

FIG. 4 is a schematic structural cross-sectional view of yet another solar cell according to an embodiment of the present application.

FIG. 5 is a schematic structural cross-sectional view of still another solar cell according to an embodiment of the present application.

Reference signs:

10, substrate layer; 1, first electrode; 2, second electrode; 3, perovskite layer; 4, first interface passivation layer; 5, second interface passivation layer; 6, hole transport layer; 61, first sub-layer; 62, second sub-layer; 7, electron transport layer; 71, third sub-layer; 72, fourth sub-layer; 8, dense barrier layer.

DETAILED DESCRIPTION

To make the objectives, features, and advantages of the present application more apparent and understandable, the specific embodiments of the present application are described in detail below with reference to the accompanying drawings. In the following description, numerous specific details are set forth to provide a thorough understanding of the present application. However, the present application can be implemented in many ways different from those described herein, and those skilled in the art can make similar improvements without departing from the spirit of the present application. Therefore, the present application is not limited by the specific embodiments disclosed below.

Unless otherwise required by the context, throughout the specification and claims, the terms "comprise" and "include" are interpreted in an open, inclusive sense, meaning "include, but is not limited to." In the description of the specification, terms such as "an embodiment," "some embodiments," "exemplary embodiment," "exemplarily," or "some examples" are intended to indicate that the specified features, structures, materials, or characteristics associated with the embodiments or examples are included in at least one embodiment or example of the present application. The above terms indicates that they are not necessarily included in the same embodiment or example. The specified features, structures, materials, or characteristics may be included in any one or more embodiments or examples in any suitable manner.

Exemplary embodiments are described herein with reference to cross-sectional views and/or plan views that are idealized exemplary drawings. In the drawings, the thickness of layers and regions may be exaggerated for clarity. Therefore, the shapes shown in the drawings can include variations due to, for example, manufacturing techniques and/or tolerances. Thus, exemplary embodiments should not be construed as limited to the shapes of regions illustrated herein but should include deviations in shape resulting from, for example, manufacturing. For instance, an etched region shown as a rectangle can typically have curved features. Accordingly, the regions shown in the drawings are schematic in nature, and the drawings are not intended to illustrate the actual shapes of the regions of a device and are not intended to limit the scope of exemplary embodiments.

In the present application, unless otherwise specified, "one or more" refers to one, two, or more.

In the present application, terms such as "for example", "such as", "example", or "exemplarily" are used for descriptive purposes, indicating that different technical solutions mentioned before and after the terms are related contents, but they should not be understood as limiting the preceding technical solution or as limiting the scope of protection of the present application. In the present application, unless otherwise specified, A (e.g., B) means that B is a non-limiting example of A, and can be interpreted as that A is not limited to B.

In the present application, terms such as "optionally," "optional," and "option" mean that the specified feature is not mandatory, indicating either of the two parallel options: "present" or "absent" of the feature. If the term "optionally" or the like appears multiple times in the same technical solution, unless specifically stated otherwise, and there are no contradictions or mutually exclusive conditions, each "optional" choice is considered independently.

In the present application, in the terms such as "first aspect," "second aspect," "third aspect," "fourth aspect," the terms "first," "second," "third," "fourth," etc., are used solely for descriptive purposes and should not be interpreted as indicating or implying relative importance or quantity, nor as implying the importance or quantity of the indicated technical features.

Unless otherwise defined, all technical and scientific terms used herein have the same meanings as commonly understood by those skilled in the technical field of the present application. The terms used in the specification of the present application are solely for the purpose of describing specific embodiments and are not intended to limit the present application.

In the present application, an open-ended description for the technical features includes not only a close-ended technical solution consisting of the recited technical features, but also an open-ended technical solution including the recited technical features.

In the present application, unless otherwise specified, when a numerical interval (i.e., a numerical range) is referred to, the suitable values are considered as continuously distributed within this numerical interval and include both endpoints of the numerical range (i.e., the minimum value and the maximum value), as well as every value between the two endpoints. Unless otherwise specified, when a numerical interval is referred to as encompassing only integers within the numerical interval, it includes the integers at both endpoints of the numerical interval, and every integer between the endpoints, equivalent to directly listing each integer. Furthermore, when multiple ranges are provided to describe a feature or a characteristic, these ranges can be combined. In other words, ranges disclosed herein are to be construed to include any or all sub-ranges subsumed therein, unless otherwise specified. The "value" within the numerical interval can be any quantitative value, such as a number, a percentage, a ratio, etc. The "numerical interval" can broadly encompass quantitative intervals, such as a percentage interval, a proportion interval, a ratio interval, etc.

In the present application, fill factor (FF) refers to the ratio of the actual maximum obtainable power ($P_m$ or $V_{mp} \times J_{mp}$) to the theoretical (rather than actually obtainable) power, ($J_{sc} \times V_{oc}$). Accordingly, FF can be determined using the equation:

$$FF = (V_{mp} \times J_{mp})/(J_{sc} \times V_{oc})$$

where $J_{mp}$ and $V_{mp}$ represent the current density and voltage at the maximum power point ($P_m$), respectively, which is obtained by varying the resistance in the circuit until $J \times V$ is at its greatest value; and $J_{sc}$ and $V_{oc}$ represent the short-circuit current and the open-circuit voltage, respectively. The fill factor is a key parameter for evaluating the performance of solar cells. Commercial solar cells typically have a fill factor of about 60% or higher.

In the present application, the open-circuit voltage ($V_{oc}$) is the difference in the electrical potentials between the anode and the cathode of a device when disconnected from an external load.

In the present application, the power conversion efficiency (PCE) of a solar cell is the percentage of power converted from absorbed light to electrical energy. The power conversion efficiency (PCE) of a solar cell can be calculated by dividing the maximum power point ($P_m$) by the incident light irradiance (E, in $W/m^2$) and the surface area ($A_c$ in $m^2$) of the solar cell under standard test conditions (STC). STC typically refers to a spectrum at a temperature of 25 °C, an irradiance of 1000 $W/m^2$, and an air mass of 1.5 (AM1.5).

In the present application, where a method involves multiple steps, unless otherwise specified herein, the sequence of steps is not strictly limited, and the steps may be performed in an order different from that described.

Moreover, any step may include multiple sub-steps or multiple stages, these sub-steps or stages are not necessarily performed at the same time, but may be performed at different times. These sub-steps or stages are not necessarily to be sequentially performed, but can be performed alternately or in turn with at least some of the sub-steps or stages of other steps.

Compared to organic passivation materials, inorganic passivation materials are expected to enhance the stability of perovskite devices due to their superior chemical stability while passivating the perovskite interface.

For example, in related art, there have been reports of inorganic materials single-sided passivating the perovskite layer. Specifically, halides of alkali metals are prepared on the surface of the perovskite layer facing the electron transport layer for single-sided passivation, while the surface of the perovskite layer facing the hole transport layer is still passivated using organic passivation materials. Consequently, the current solar cells still suffer from poor stability.

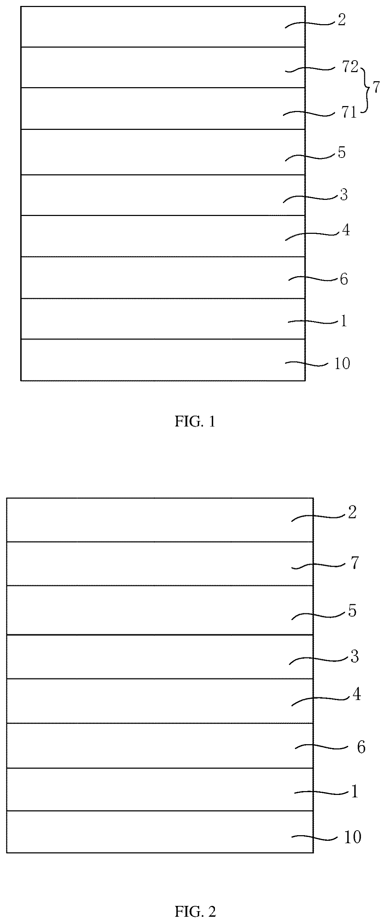

To address the above technical issues, in a first aspect, some embodiments of the present application provide a solar cell. Referring to FIG. 1 to FIG. 4, the solar cell includes a substrate layer 10, a first electrode 1, a second electrode 2, a perovskite layer 3, a first interface passivation layer 4, and a second interface passivation layer 5. The perovskite layer 3 is disposed between the first electrode 1 and the second electrode 2. The first interface passivation layer 4 is disposed between the perovskite layer 3 and the first electrode 1, and the second interface passivation layer 5 is disposed between the perovskite layer 3 and the second electrode 2.

The first electrode 1 and the second electrode 2 can be an anode and a cathode, respectively, which are not specifically limited herein.

In the case where the first electrode 1 is an anode and the second electrode 2 is a cathode, as shown in FIGs. 1 to 4, the substrate layer 10 can be disposed on the side of the first electrode 1 facing away from the perovskite layer 3, in which case the solar cell is an inverted solar cell. Alternatively, the substrate layer 10 can be disposed on the side of the second electrode 2 facing away from the perovskite layer 3, in which case the solar cell is a normal solar cell.

In the case where the first electrode 1 is a cathode and the second electrode 2 is an anode, the substrate layer 10 can be disposed on the side of the first electrode 1 facing away from the perovskite layer 3, in which case the solar cell is a normal solar cell. Alternatively, the substrate layer 10 can be disposed on the side of the second electrode 2 facing away from the perovskite layer 3, in which case the solar cell is an inverted solar cell.

In the present application, FIGs. 1 to 4 only shows the case where the substrate layer 10 is disposed on the side of the first electrode 1 facing away from the perovskite layer 3.

In some embodiments, as shown in FIGs. 1 to 4, the solar cell can further include a hole transport layer 6. The hole transport layer 6 is disposed between the first electrode 1 and the first interface passivation layer 4.

In some other embodiments, as shown in FIGs. 1 to 4, the solar cell can further include an electron transport layer 7. The electron transport layer 7 is disposed between the second electrode 2 and the second interface passivation layer 5.

In the above two embodiments, the solar cell is an inverted solar cell. Additionally, the solar cell can include either or both of the hole transport layer 6 and the electron transport layer 7 to facilitate the efficient transport of holes and electrons.

In some embodiments, the solar cell can be a single-junction perovskite cell or a tandem perovskite cell.

A single-junction perovskite cell only includes the "sandwich" structure of the perovskite cell. A tandem perovskite cell refers to stacked perovskite layers or a perovskite layer stacked on a conventional crystalline silicon solar cell, forming a "tandem" cell capable of absorbing a broader spectrum of sunlight.

In some embodiments, the solar cell includes a first cell and a second cell stacked on the first cell. The first cell includes the above-described first interface passivation layer, perovskite layer, and second interface passivation layer. The second cell is any one of a perovskite cell, a silicon-based solar cell, a copper indium gallium selenide solar cell, or an organic thin-film solar cell.

In these embodiments, the solar cell is a tandem perovskite cell.

In this case, taking the substrate layer being disposed on the side of the first electrode facing away from the perovskite layer as an example, the first electrode can serve as a bottom electrode of the tandem perovskite cell, the second electrode can serve as a top electrode of the tandem perovskite cell, and the first cell and the second cell are stacked between the first electrode and the second electrode.

In some optional embodiments, the first cell is disposed farther from the substrate layer 10 than the second cell, which facilitates the fabrication of the perovskite cell as a wide-bandgap top cell and the second cell as a narrow-bandgap bottom cell. This structure allows the wide-bandgap top cell to absorb high-energy photons while the narrow-bandgap bottom cell also absorbs energy of photons, thereby improving photon utilization efficiency.

In some embodiments, whether the solar cell is a single-junction perovskite cell or a tandem perovskite cell, the materials of the first interface passivation layer 4 and the second interface passivation layer 5 each include an inorganic material.

Different from organic materials that use specific functional groups to passivate interface defects of the perovskite layer, the inorganic materials can form a field-effect passivation with fixed charges at the interface of the perovskite layer 3, thereby passivating the interface of the perovskite layer 3. Additionally, compared with organic materials, the inorganic materials exhibit higher compactness when formed at the interface of the perovskite layer. Therefore, the inorganic materials can also serve to suppress ion migration between the perovskite layer 3 and the metal electrode. For example, if the first interface passivation layer 4 and the second interface passivation layer 5 are not sufficiently dense and fail to fully cover the interface between the perovskite layer 3 and the metal electrode, organic cations and halide anions from the perovskite layer 3 may pass through the electron transport layer 7 or the hole transport layer 6 to reach the metal electrode, reacting with and damaging the metal electrode. Similarly, metal ions from the metal electrode may migrate into the perovskite layer 3, causing damage to the perovskite layer 3, which leads to reduced material stability and significant performance degradation of the solar cell.

In the embodiments of the present application, by disposing the first interface passivation layer 4 between the first electrode 1 and the perovskite layer 3, and disposing the second interface passivation layer 5 between the second electrode 2 and the perovskite layer 3, the first interface passivation layer 4 and the second interface passivation layer 5 both including inorganic materials, following effects can be achieved. On the one hand, the stability of the solar cell can be further improved compared with the related art where an inorganic material is only formed on one side of the perovskite layer 3 for passivation. On the other hand, these inorganic materials form denser passivation layers compared to organic materials, enabling the first interface passivation layer 4 and the second interface passivation layer 5 to effectively suppress ion migration between the perovskite layer 3 and the metal electrodes. As a result, stability decrease issue in the solar cell caused by ion migration can be alleviated, thereby further enhancing the material and performance stability of the solar cell and reducing performance degradation.

The materials of the first interface passivation layer 4 and the second interface passivation layer 5 are not specifically limited, provided that the materials of the first interface passivation layer 4 and the second interface passivation layer 5 can passivate the interface of the perovskite layer 3.

In some embodiments, the materials of the first interface passivation layer 4 and the second interface passivation layer 5 can be the same or different.

In some embodiments, the material of the first interface passivation layer 4 includes one or more of aluminum oxide, silicon oxide, or magnesium oxide; and/or the material of the second interface passivation layer 5 includes one or more of aluminum oxide, silicon oxide, or magnesium oxide.

In these embodiments, by using these inorganic materials, on the one hand, as these inorganic materials have excellent compactness, ion migration between the perovskite layer 3 and the metal electrodes can be effectively suppressed and reactions between halide anions in the perovskite layer and the metal electrodes that could damage the metal electrodes can be prevented, thus improving the material stability and performance stability of the solar cell. On the other hand, compared with the single-sided inorganic material passivation using halide salts of alkali metals in the related art, these inorganic materials exhibit better stability and can suppress the migration of halide ions from the perovskite layer without introducing additional halide ions, thereby further reducing reactions between halide ions and the metal electrodes and enhancing the stability of the solar cell.

In some embodiments, the thickness of the first interface passivation layer 4 is in a range from about 0.1 nm to about 50 nm. In some other embodiments, the thickness of the second interface passivation layer 5 is in a range from about 0.1 nm to about 50 nm.

In the above embodiments, by controlling the thickness of the first interface passivation layer 4 and the second interface passivation layer 5 within the above ranges, charge carriers can be efficiently transported while ion migration between the perovskite layer 3 and the metal electrodes can be effectively suppressed. In addition, the passivation effect on the perovskite layer 3 can be enhanced, which achieves excellent interface passivation at both interfaces of the perovskite layer while reducing ion migration at the two interfaces.

In some embodiments, as shown in FIGs. 1 to 4, both the first interface passivation layer 4 and the second interface passivation layer 5 fully cover the perovskite layer 3.

In these embodiments, the first interface passivation layer 4 and the second interface passivation layer 5 can be dense layers that fully cover the perovskite layer, such as dense layers of aluminum oxide, silicon oxide, or titanium oxide, which can be prepared using processes such as evaporation deposition or atomic layer deposition. The dense layers are free of voids, preventing incomplete coverage, thereby more effectively suppressing ion migration between the perovskite layer 3 and the metal electrodes, further enhancing the material and performance stability of the solar cell.

It should be noted that, in the above solar cell, the hole transport layer 6 can be a single-layer structure or a multi-layer structure, and the electron transport layer 7 can also have a single-layer structure or a multi-layer structure, which are not specifically limited herein.

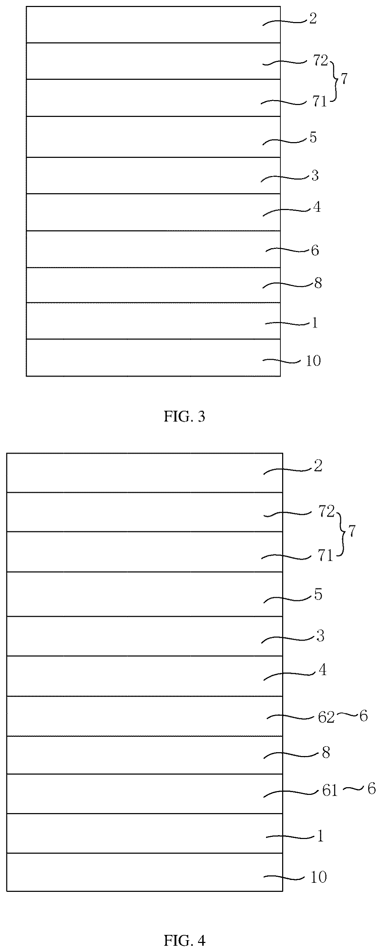

In the case where the hole transport layer 6 is a single-layer structure, the material of the hole transport layer can include any organic and/or inorganic material with hole transport functionality. In the case where the hole transport layer 6 is a multi-layer structure, the materials of different layers in the multi-layer structure can be the same or different, and each layer can independently include any organic and/or inorganic material with hole transport functionality. FIGs. 1 to 3 shows the hole transport layer 6 as a single-layer structure, and FIG. 4 shows the hole transport layer 6 including a first sub-layer 61 and a second sub-layer 62.

In the case where the electron transport layer 7 is a single-layer structure, the material of the electron transport layer 7 can include any organic and/or inorganic material with electron transport functionality. In the case where the electron transport layer 7 is a multi-layer structure, the materials of different layers in the multi-layer structure can be the same or different, and each layer can independently include any organic and/or inorganic material with electron transport functionality. FIGs. 1 and 2 shows the electron transport layer 7 as a single-layer structure, and FIGs. 3 and 4 shows the electron transport layer 7 including a third sub-layer 71 and a fourth sub-layer 72.

In some embodiments, the material of the perovskite layer 3 can include a perovskite material with a general chemical formula $ABX_3$, where A is a monovalent cation, including but not limited to cesium ion ($Cs^+$), rubidium ion ($Rb^+$), methylammonium ion ($CH_3NH_3^+$), formamidinium ion ($(CH_2(NH_2)_2^+)$), or a combination thereof; B is a divalent cation, including but not limited to lead ion ($Pb^{2+}$), copper ion ($Cu^{2+}$), zinc ion ($Zn^{2+}$), gallium ion ($Ga^{2+}$), tin ion ($Sn^{2+}$), calcium ion ($Ca^{2+}$), or a combination thereof; X is a monovalent anion, including but not limited to iodide ion ($I^-$), bromide ion ($Br^-$), chloride ion ($Cl^-$), fluoride ion ($F$), thiocyanate ion ($SCN^-$), or a combination thereof. The thickness of the perovskite layer can be in a range from about 10 nm to about 100 $\mu$m, with a bandgap in a range from about 0.9 eV to about 3.0 eV.

In some embodiments, the materials of the first electrode 1 and the second electrode 2 can include any conductive materials, such as transparent conductive oxide materials or metal materials, which are not specifically limited herein.

In the following embodiments, the single-layer structure of the electron transport layer 7 is taken as an example for description. The skilled person in the art can understand that the description of the electron transport layer 7 below is also applicable to cases where the electron transport layer 7 is a multi-layer structure.

It should be noted that, in the related art, fullerene compounds include fullerene ($C_{60}$) and its derivatives. The fullerene compounds are widely used in solar cells due to their high electron mobility and great electron extraction capability. However, energy level mismatch often occurs between the perovskite layer and fullerene $C_{60}$, leading to increased carrier recombination at the perovskite-fullerene interface.

In some embodiments of the present application, the material of the electron transport layer 7 includes two or more of a fullerene compound, graphene, or carbon nanotubes.

Graphene is a two-dimensional carbon nanomaterial composed of carbon atoms with $sp^2$ hybridized orbitals, exhibiting excellent optical, electrical, and mechanical properties. Carbon nanotubes, also known as buckytubes, are a one-dimensional quantum material with a special structure, having nanoscale radial dimensions and microscale axial dimensions. Carbon nanotubes have a unique structure and excellent mechanical, electrical, and chemical properties.

In these embodiments, by forming the hole transport layer from two or more materials selected from a fullerene compound, graphene, and carbon nanotubes, the energy level of the electron transport layer of the solar cell can be adjusted, addressing the energy level mismatch issue between the perovskite layer and $C_{60}$ in the related art, thereby further reducing interface recombination between the perovskite layer and the electron transport layer and reducing open-circuit voltage losses.

In some embodiments, the material of the electron transport layer 7 at least includes graphene and/or carbon nanotubes.

In these embodiments, different types of carbon nanomaterials are adopted to further adjust the energy level of the electron transport layer of the solar cell, thereby matching energy levels of the electron transport layer and the perovskite layer, reducing interface recombination between the perovskite layer and the electron transport layer, and reducing open-circuit voltage losses.

In some embodiments, the electron transport layer 7 includes two or more materials selected from a fullerene compound, graphene, and carbon nanotubes, and the thickness of the electron transport layer 7 can be in a range from about 0.1 nm to about 100 nm.

It should also be noted that, in the related art, $C_{60}$ is commonly used in the electron transport layer of inverted solar cells, which is mainly due to the high electron mobility and charge extraction capability of $C_{60}$, as well as that $C_{60}$ can be deposited on the perovskite layer via thermal evaporation without damaging the perovskite layer. However, $C_{60}$ is expensive, which hinders the commercial application of perovskite cells. Additionally, $C_{60}$ exhibits significant absorption in the short-wavelength range, making it less suitable for application in perovskite/crystalline silicon or perovskite/CIGS tandem devices based on the inverted perovskite structure. Furthermore, the weak interfacial bonding between $C_{60}$ and the perovskite layer results in poor mechanical stress stability of the device. Therefore, developing alternative electron transport layer materials to replace $C_{60}$ is crucial for advancing the commercial application of perovskite cells.

Metal oxide electron transport materials, such as ZnO, $TiO_2$, and $SnO_2$, have been widely used in normal solar cells due to their low cost, wide bandgap, high mobility, and low absorption in the wavelength range from 300 nm to 1200 nm. However, the performance of the metal oxide electron transport materials as electron transport layers in inverted solar cells is relatively poor due to their preparation processes. For example, these metal oxide electron transport materials can be prepared by using atomic layer deposition (ALD) or reactive plasma deposition (RPD) in inverted solar cells. However, if the metal oxide electron transport materials are directly formed on the perovskite layer, their precursors may react with the perovskite layer, leading to poor performance. If the metal oxide electron transport materials are directly deposited on the perovskite layer using RPD, the high ion bombardment energy may damage the perovskite layer.

In view of the above, in some embodiments, as shown in FIG. 2, the substrate layer 10 is disposed on the surface of the first electrode 1 facing away from the perovskite layer 3; the electron transport layer 7 is disposed on the surface of the second interface passivation layer 5 facing away from the perovskite layer 3; and the material of the electron transport layer 7 includes one or more selected from zinc oxide (ZnO), titanium oxide (e.g., $TiO_2$), tin oxide (e.g., $SnO_2$), and niobium oxide (e.g., $Nb_2O_5$).

In these embodiments, the electron transport layer 7 is disposed on the surface of the second interface passivation layer 5 facing away from the perovskite layer 3, and the solar cell is an inverted solar cell. In this case, bromide (Br) ions from the perovskite layer 3 can be blocked from entering the electron transport layer 7 by the second interface passivation layer 5, and the second interface passivation layer 5 can passivate the interface of the perovskite layer 3, allowing the metal oxide electron transport materials to be used in high-efficiency inverted solar cells, thereby reducing preparation costs of inverted solar cells.

Additionally, the second interface passivation layer 5 can effectively reduce sputtering damage to the perovskite layer caused by preparation of the metal oxide electron transport materials using RPD.

To effectively suppress ion migration between the electron transport layer and the perovskite layer, enhance the passivation effect, and reduce sputtering damage to the perovskite layer caused by preparation of the metal oxide electron transport materials using RPD, in some optional embodiments, the thickness of the second interface passivation layer 5 is in a range from about 0.1 nm to about 5 nm.

In some embodiments, the material of the electron transport layer 7 includes one or more selected from zinc oxide (ZnO), titanium oxide (e.g., $TiO_2$), tin oxide (e.g., $SnO_2$), and niobium oxide (e.g., $Nb_2O_5$), and the thickness of the electron transport layer 7 is in a range from about 1 nm to about 100 nm.

In these embodiments, the thickness of the electron transport layer 7 ranged from about 1 nm to about 100 nm can endow the solar cell with high electron transport performance.

Regarding the hole transport layer 6, similar to the electron transport layer 7, the hole transport layer 6 can also be a single-layer structure or a multi-layer structure. In the following embodiments, both the single-layer structure and the multi-layer structure of the hole transport layer 6 are taken as examples for description.

In the related art, in the inverted solar cell, the hole transport layer 6 is disposed between a transparent conductive oxide layer and a perovskite layer. Particularly for a self-assembled monolayer (SAM), when prepared using a solution-based method, the SAM is difficult to completely cover the transparent conductive oxide layer and the metal oxide hole transport materials, leading to direct contact between the perovskite layer and the transparent conductive oxide layer. As a result, non-radiative recombination at the interface of the perovskite layer 3 may be increased, reducing the efficiency of the solar cell and decreasing the stability of the solar cell.

In view of the above, in some embodiments of the present application, referring to FIG. 3, the hole transport layer 6 is disposed on the surface of the first interface passivation layer 4 facing away from the perovskite layer 3. The solar cell further includes a substrate layer 10 and a dense barrier layer 8 disposed between the hole transport layer 6 and the first electrode 1. The substrate layer 10 is disposed on the surface of the first electrode 1 facing away from the perovskite layer 3. The dense barrier layer 8 is configured to prevent contact between the perovskite layer 3 and the first electrode 1 while allowing holes to be transported between the first electrode 1 and the hole transport layer 6.

In these embodiments, the solar cell is an inverted solar cell. By disposing a dense barrier layer 8 between the hole transport layer 6 and the first electrode 1, when the hole transport layer 6 does not completely cover the first electrode 1 and the first interface passivation layer 4 does not completely cover the perovskite layer 3, the dense barrier layer 8 allows holes to be transported between the first electrode 1 and the hole transport layer 6 while preventing contact between the perovskite layer 3 and the second electrode 2. Thus, the dense barrier layer 8 can prevent direct contact between the perovskite layer 3 and the transparent conductive oxide layer, which would otherwise cause non-radiative recombination, thereby improving the efficiency and stability of the solar cell.

In some other embodiments, the hole transport layer 6 can include a first sub-layer 61 and a second sub-layer 62. The first sub-layer 61 can include a metal oxide hole transport material, the second sub-layer 62 can include a SAM, and the first electrode 1 can be a transparent conductive oxide layer. The dense barrier layer 8 can be disposed either between the first sub-layer 61 and the second sub-layer 62 or between the first sub-layer 61 and the first electrode 1. In both cases, the dense barrier layer 8 facilitates hole transport while preventing contact between the perovskite layer 3 and the first electrode 1.

In some embodiments, the material of the dense barrier layer 8 includes one or more selected from aluminum oxide, silicon oxide, and titanium oxide.

In these embodiments, when the dense barrier layer 8 is disposed between the first sub-layer 61 and the second sub-layer 62, the SAM in the second sub-layer 62 can achieve self-assembly through a dehydration reaction between its anchoring groups (e.g., phosphate groups, carboxylic acid groups, or thiols) and hydroxyl groups on the surface of the dense barrier layer 8, achieving anchoring bonding between the SAM and the dense barrier layer 8.

In some embodiments, the thickness of the dense barrier layer 8 is in a range from about 0.1 nm to about 5 nm.

In some embodiments, the thickness of the second sub-layer 62 is in a range from about 0.1 nm to about 20 nm.

In a second aspect, some embodiments of the present application provide a method for preparing the solar cell as described in the first aspect, the preparation method including:

forming a first electrode on a substrate layer;
sequentially forming a first interface passivation layer, a perovskite layer, a second interface passivation layer, and a second electrode on the side of the first electrode facing away from the substrate layer; wherein the perovskite layer is formed between the first electrode and the second electrode, the first interface passivation layer is formed between the first electrode and the perovskite layer, the second interface passivation layer is formed between the second electrode and the perovskite layer, and the materials of the first interface passivation layer and the second interface passivation layer each include an inorganic material.

The solar cell can be a single-junction perovskite cell or a tandem perovskite cell, which is not specifically limited herein.

In the case where the solar cell is a single-junction perovskite cell, the first electrode, the first interface passivation layer, the perovskite layer, the second interface passivation layer, and the second electrode can be sequentially formed on the substrate layer of the solar cell. Alternatively, the second electrode, the second interface passivation layer, the perovskite layer, the first interface passivation layer, and the first electrode can be sequentially formed on the substrate layer of the solar cell.

In the case where the solar cell is a tandem perovskite cell, the first electrode can serve as a bottom electrode of the tandem perovskite cell, and the second electrode can serve as a top electrode of the tandem perovskite cell. The first electrode, the bottom cell, the top cell, and the second electrode can be sequentially formed on the substrate layer. Alternatively, the first electrode can serve as a top electrode of the tandem perovskite cell, and the second electrode the serve as a bottom electrode of the tandem perovskite cell. The second electrode, the bottom cell, the top cell, and the first electrode can be sequentially formed on the substrate layer.

The top cell can include the first interface passivation layer, the perovskite layer, and the second interface passivation layer. When the first electrode is the bottom electrode of the tandem perovskite cell, the first interface passivation layer, the perovskite layer, and the second interface passivation layer can be sequentially formed on the bottom cell. When the first electrode is the top electrode of the tandem perovskite cell, the second interface passivation layer, the perovskite layer, and the first interface passivation layer can be sequentially formed on the bottom cell.

In the embodiments of the present application, FIGs. 1 to 4 only show the cases where the first electrode 1, the first interface passivation layer 4, the perovskite layer 3, the second interface passivation layer 5, and the second electrode 2 are sequentially formed on the substrate layer 10.

The technical effects of the method for preparing the solar cell provided by the embodiments of the present application are the same as those of the solar cell provided by the embodiments of the present application, and thus are not repeated herein.

The specific methods for forming the first interface passivation layer 4 and the second interface passivation layer 5 are not limited, as long as the first interface passivation layer 4 and the second interface passivation layer 5 can be formed on opposite sides of the perovskite layer 3.

In some embodiments, the first interface passivation layer and the second interface passivation layer are independently prepared using atomic layer deposition, magnetron sputtering, electron beam evaporation, or plasma-enhanced chemical vapor deposition (PECVD).

In these embodiments, the deposition of inorganic materials can be achieved to form the first interface passivation layer and the second interface passivation layer.

In some embodiments, referring to FIG. 2, the solar cell further includes an electron transport layer 7, and the preparation method further includes:

Before forming the second electrode 2 on the second interface passivation layer 5, forming the electron transport layer 7 on the surface of the second interface passivation layer 5 facing away from the perovskite layer 3 through evaporation deposition, wherein the material of the electron transport layer 7 includes two or more selected from fullerene, a derivative of fullerene, graphene, and carbon nanotubes.

In these embodiments, the solar cell is an inverted solar cell. By using an evaporation deposition method to prepare the electron transport layer, an electron transport layer with a relatively small thickness can be achieved, enabling conformal growth of the electron transport layer on rough surfaces in perovskite/crystalline silicon tandem devices, which facilitates its application in the perovskite/crystalline silicon tandem devices. Additionally, precise control of nanoscale thickness over large areas of films can be achieved, which is beneficial for fabricating high-efficiency, large-area perovskite cells.

In some embodiments, the solar cell can be a normal solar cell. In this case, the electron transport layer can also be formed using an evaporation deposition method, similarly resulting in a thin and uniform electron transport layer, which is suitable for conformal growth of the electron transport layer on rough surfaces in perovskite/crystalline silicon tandem devices.

In some embodiments, the evaporation deposition method includes at least one of thermal evaporation, electron beam evaporation, or close-space sublimation.

In some embodiments, the electron transport layer is formed by co-evaporation of a plurality of sources; or the electron transport layer is formed by evaporation of a single source of physically mixed materials.

In some other embodiments, referring to FIG. 2, the solar cell further includes an electron transport layer 7, and the preparation method further includes:

before forming the second electrode 2 on the second interface passivation layer 5, depositing the electron transport layer 7 on the surface of the second interface passivation layer 5 facing away from the perovskite layer 3 using one of the following methods:

atomic layer deposition, reactive plasma deposition (RPD), magnetron sputtering, slot-die coating, blade coating, spray coating, or inkjet printing;

wherein the material of the electron transport layer 7 includes one or more selected from zinc oxide (ZnO), titanium oxide (e.g., $TiO_2$), tin oxide (e.g., $SnO_2$), and niobium oxide (e.g., $Nb_2O_5$).

In these embodiments, the metal oxide electron transport materials can be used in inverted solar cells. Additionally, the second interface passivation layer 5 can effectively reduce sputtering damage to the perovskite layer caused by preparation of the metal oxide electron transport materials using RPD.

In some embodiments, referring to FIGs. 3 and 4, the solar cell further includes a hole transport layer 6 and a dense barrier layer 8, and the preparation method further includes:

before forming the first interface passivation layer 4 on the first electrode 1, sequentially forming the dense barrier layer 8 and the hole transport layer 6 on the first electrode 1, wherein the dense barrier layer 8 is configured to prevent contact between the perovskite layer 3 and the first electrode 1 while allowing holes to be transported between the first electrode 1 and the hole transport layer 6.

In these embodiments, by sequentially forming the dense barrier layer 8 and the hole transport layer 6 on the first electrode 1, it can be avoided that the first electrode 1 is in direct contact with the perovskite layer 3 due to that the perovskite layer 3 is not completely covered with the subsequently prepared hole transport layer 6 and first interface passivation layer 4. As a result, the non-radiative recombination at the interface of the perovskite layer 3 can be reduced, thereby improving the efficiency and stability of the solar cell. Meanwhile, the introduction of the dense barrier layer 8 does not affect hole transport between the first electrode 1 and the perovskite layer 3.

FIG. 3 shows that the dense barrier layer 8 and the hole transport layer 6 are sequentially formed on the first electrode 1, and the hole transport layer 6 is a single-layer structure.

In some embodiments of the present application, the material of the dense barrier layer 8 includes one or more selected from aluminum oxide, silicon oxide, and magnesium oxide.

In these embodiments, the dense barrier layer 8 is a dense oxide layer.

Referring to FIG. 4, the hole transport layer 6 can be a multi-layer structure. For example, the hole transport layer 6 can include a first sub-layer 61 and a second sub-layer 62, where the first sub-layer 61 can be a metal oxide layer, and the second sub-layer 62 can be a self-assembled monolayer (SAM). Before forming the first interface passivation layer 4 on the first electrode 1, the dense barrier layer 8, the first sub-layer 61, and the second sub-layer 62 can be sequentially formed on the first electrode 1. Alternatively, as shown in FIG. 4, the first sub-layer 61, the dense barrier layer 8, and the second sub-layer 62 can be sequentially formed on the first electrode 1. In both cases, the dense barrier layer 8 facilitates hole transport while preventing contact between the perovskite layer 3 and the first electrode 1.

When the dense barrier layer 8 is disposed between the first sub-layer 61 and the second sub-layer 62, the SAM can achieve self-assembly through a dehydration reaction between its anchoring groups (e.g., phosphate groups, carboxylic acid groups, or thiols) and hydroxyl groups on the surface of the dense barrier layer 8, enabling anchoring bonding between the SAM and the dense barrier layer 8.

Due to the self-limiting nature of the chemical reactions of SAM materials, the thickness of the SAM is typically on the order of a few nanometers, resulting in high optical transmittance and enabling conformal growth on substrates with complex morphologies. Therefore, SAM materials are suitable for perovskite solar cells with various substrate layers, such as in perovskite/crystalline silicon tandem devices. Additionally, SAM materials exhibit great hole extraction capability and less non-radiative recombination as less contact with the perovskite layer, making them suitable for further improving the efficiency of inverted solar cells.

In some embodiments, the second sub-layer can be prepared using a solution-based method.

Specifically, the SAM is prepared using a solution-based method. In the above embodiments, this approach can reduce direct contact between the transparent conductive oxide layer and the perovskite layer caused by the SAM not completely covering the transparent conductive oxide layer.

In some embodiments, the first sub-layer can be prepared using one of the following methods: atomic layer deposition, RPD, magnetron sputtering, slot-die coating, blade coating, spray coating, or inkjet printing.

In some embodiments, the perovskite layer can be prepared using one of the following methods: spin coating, blade coating, evaporation deposition, printing, spray coating, spray pyrolysis, or slot-die coating.

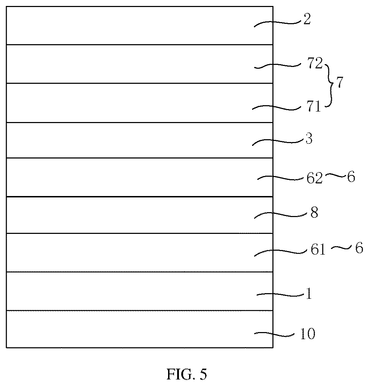

In a third aspect, some embodiments of the present application provide a solar cell. Referring to FIG. 5, the solar cell includes a substrate layer 10, a first electrode 1, a second electrode 2, a perovskite layer 3, a hole transport layer 6, and a dense barrier layer 8. The perovskite layer 3 is disposed between the first electrode 1 and the second electrode 2. The hole transport layer 6 is disposed between the perovskite layer 3 and the first electrode 1. The dense barrier layer 8 is disposed between the first electrode 1 and the perovskite layer 3. The dense barrier layer 8 is configured to prevent contact between the perovskite layer 3 and the first electrode 1 while allowing holes to be transported between the first electrode 1 and the hole transport layer 6.

The first electrode 1 is an anode, and the second electrode 2 is a cathode. In this case, the substrate layer 10 can be disposed on the side of the first electrode 1 facing away from the perovskite layer 3, resulting in an inverted solar cell. Alternatively, the substrate layer 10 can be disposed on the side of the second electrode 2 facing away from the perovskite layer 3, resulting in a normal solar cell.

Taking the inverted solar cell as an example, in the related art, the hole transport layer 6 is disposed between a transparent conductive oxide layer and a perovskite layer. Particularly for the SAM, when prepared using a solution-based method, the SAM is difficult to completely cover the transparent conductive oxide layer and the metal oxide hole transport materials, leading to direct contact between the perovskite layer and the transparent conductive oxide layer. As a result, non-radiative recombination at the interface of the perovskite layer 3 may be increased, reducing the efficiency of the solar cell and decreasing the stability of the solar cell.

In the solar cell provided by the embodiments of the present application, by disposing a dense barrier layer 8 between the hole transport layer 6 and the first electrode 1, when the hole transport layer 6 does not completely cover the first electrode 1, the dense barrier layer 8 allows holes to be transported between the first electrode 1 and the hole transport layer 6 while preventing contact between the perovskite layer 3 and the first electrode 1. Thus, the dense barrier layer 8 can prevent direct contact between the perovskite layer 3 and the transparent conductive oxide layer, which would otherwise cause non-radiative recombination, thereby improving the efficiency and stability of the solar cell.

In some embodiments, the material of the dense barrier layer 8 includes one or more selected from aluminum oxide, silicon oxide, and magnesium oxide.

In these embodiments, these oxides are relatively dense, which can prevent contact between the first electrode 1 and the perovskite layer 3 while allowing hole transport.

In some embodiments, the thickness of the dense barrier layer 8 is in a range from about 0.1 nm to about 5 nm.

In these embodiments, the dense barrier layer 8 is relatively thin, which does not impede hole transport.

In some other embodiments, referring to FIG. 5, the hole transport layer 6 can be a multi-layer structure. For example, the hole transport layer 6 can include a first sub-layer 61 and a second sub-layer 62. The first sub-layer 61 can be a metal oxide layer, and the second sub-layer 62 can be a SAM. In this case, before forming the first interface passivation layer 4 on the first electrode 1, the dense barrier layer 8, the first sub-layer 61, and the second sub-layer 62 can be sequentially formed on the first electrode 1. Alternatively, referring to FIG. 5, the first sub-layer 61, the dense barrier layer 8, and the second sub-layer 62 can be sequentially formed on the first electrode 1. In both cases, the dense barrier layer 8 facilitates hole transport while preventing contact between the perovskite layer 3 and the first electrode 1.

When the dense barrier layer 8 is disposed between the first sub-layer 61 and the second sub-layer 62, the SAM can achieve self-assembly through a dehydration reaction between its anchoring groups (e.g., phosphate groups, carboxylic acid groups, or thiols) and hydroxyl groups on the surface of the dense barrier layer 8, achieving anchoring bonding between the SAM and the dense barrier layer 8.

Due to the self-limiting nature of the chemical reactions of SAM materials, the thickness of the SAM is typically on the order of a few nanometers, resulting in high optical transmittance and enabling conformal growth on substrates with complex morphologies. Therefore, SAM materials are suitable for perovskite solar cells with various substrate layers, such as in perovskite/crystalline silicon tandem devices. Additionally, SAM materials exhibit great hole extraction capability and less non-radiative recombination as less contact with the perovskite layer, making them suitable for further improving the efficiency of inverted solar cells.

In some embodiments, the solar cell can further include an electron transport layer 7, which can be a single-layer structure or a multi-layer structure. As shown in FIG. 5, the electron transport layer 7 is a multi-layer structure, including a third sub-layer 71 and a fourth sub-layer 72.

In a fourth aspect, some embodiments of the present application provide a method for preparing a solar cell, including:

forming a first electrode on a substrate layer;
sequentially forming a dense barrier layer, a hole transport layer, a perovskite layer, and a second electrode on the side of the first electrode facing away from the substrate layer;
wherein the dense barrier layer is configured to prevent contact between the perovskite layer and the first electrode while allowing holes to be transported between the first electrode and the hole transport layer.

The solar cell provided by the embodiments of the present application is an inverted solar cell. By sequentially forming the dense barrier layer on the first electrode, it can be avoided that the first electrode is in direct contact with the perovskite layer due to that the perovskite layer is not completely covered with the subsequently prepared hole transport layer. Particularly the SAM is difficult to completely cover the transparent conductive oxide layer and the metal oxide hole transport materials, leading to direct contact between the perovskite layer and the transparent conductive oxide layer. As a result, non-radiative recombination at the interface of the perovskite layer may be increased, reducing the efficiency of the solar cell and decreasing the stability of the solar cell. Meanwhile, the introduction of the dense barrier layer does not affect hole transport between the first electrode and the perovskite layer.

To objectively evaluate the technical effects of the embodiments of the present application, the present application is specifically and exemplarily illustrated through the following examples and comparative examples.

In the following examples and comparative examples, all raw materials are commercially available. To ensure the reliability of the experiments, the raw materials used in the examples and comparative examples below have identical physical and chemical parameters or are prepared using the same processing methods.

Example 1

A preparation method of a perovskite cell provided in Example 1 was as follows:

Step 1: a transparent glass substrate with a thickness of 1.1 mm was provided.
Step 2: an indium tin oxide (ITO) layer as a first electrode with a thickness of about 100 nm was formed on the transparent glass substrate using magnetron sputtering.
Step 3: a hole transport layer of NiO with a thickness of about 20 nm was formed on the first electrode using magnetron sputtering.
Step 4: a first interface passivation layer of $SiO_x$ with a thickness of about 1 nm was formed on the hole transport layer using magnetron sputtering.
Step 5: a perovskite layer with a thickness of about 500 nm was formed on the first interface passivation layer using slot-die coating.
Step 6: a second interface passivation layer of $AlO_x$ with a thickness of about 1 nm was formed on the perovskite layer using atomic layer deposition.
Step 7: an electron transport layer of $C_{60}$ with a thickness of about 30 nm was formed on the second interface passivation layer using thermal evaporation.
Step 8: a layer of bathocuproine (BCP, 2,9-dimethyl-4,7-diphenyl-1,10-phenanthroline) with a thickness of about 6 nm was formed on the electron transport layer of $C_{60}$ using thermal evaporation.
Step 9: an Ag electrode with a thickness of about 150 nm was formed on the BCP layer using thermal evaporation.

Example 2

The preparation method of the perovskite cell provided in Example 2 was substantially the same as that provided in Example 1 except the following differences:
In step 4, as a substitute, a dense barrier layer of $AlO_x$ was formed on the hole transport layer using atomic layer deposition, and after step 4, a self-assembled monolayer (SAM) of [2-(9H-carbazol-9-yl)ethyl]phosphonic acid (2PACz) with a thickness of about 2 nm was formed on the dense barrier layer of $AlO_x$ using slot-die coating.

Example 3

The preparation method of the perovskite cell provided in Example 3 was substantially the same as that provided in Example 1 except the following differences:
In step 4, a first interface passivation layer of $AlO_x$ was formed on the hole transport layer using atomic layer deposition.
In steps 7 to 8, as a substitute, a $SnO_2$ layer with a thickness of about 30 nm was formed on the second interface passivation layer of $AlO_x$ using atomic layer deposition.

Example 4

The preparation method of the perovskite cell provided in Example 4 was substantially the same as that provided in Example 1 except the following differences:

In step 4, as a substitute, a dense barrier layer of $AlO_x$ was formed on the hole transport layer using atomic layer deposition, and after step 4, a SAM of 2PACz with a thickness of about 2 nm was formed on the dense barrier layer of $AlO_x$ using slot-die coating.

In step 7, as a substitute, $C_{60}$ and [6,6]-phenyl-$C_{61}$-butyric acid methyl ester (PCBM) with a thickness of about 30 nm was formed using dual-source co-evaporation, wherein a mass ratio of $C_{60}$ to PCBM was 1:1.

Example 5

The preparation method of the perovskite cell provided in Example 5 was substantially the same as that provided in Example 1 except the following differences:

In step 4, as a substitute, a first interface passivation layer of $AlO_x$ with a thickness of about 1 nm was formed using atomic layer deposition.

In step 7, as a substitute, an electron transport layer including $C_{60}$ and PCBM with a thickness of about 30 nm was formed using dual-source co-evaporation on the second interface passivation layer, wherein a mass ratio of $C_{60}$ to PCBM was 1:1.

Comparative Example 1

The preparation method of the perovskite cell provided in Comparative Example 1 was substantially the same as that provided in Example 1 except the following difference:

Steps 4 and 6 were omitted.

Testing Examples

The performances of the perovskite cells provided in Examples 1 to 5 and Comparative Example 1 were tested. The specific test results are shown in Table 1:

Table 1

| Item | Voc(V) | Jsc(mA cm$^{-2}$) | FF (%) | PCE(%) |
|---|---|---|---|---|
| Comparative Example 1 | 1.190 | 20.53 | 75.58 | 18.46 |
| Example 1 | 1.221 | 20.52 | 79.49 | 19.92 |
| Example 2 | 1.244 | 20.66 | 82.56 | 21.22 |
| Example 3 | 1.224 | 20.41 | 79.44 | 19.85 |
| Example 4 | 1.250 | 20.82 | 83.49 | 21.73 |
| Example 5 | 1.237 | 20.88 | 81.84 | 21.14 |

From Table 1, it can be observed that the open-circuit voltage, fill factor, and power conversion efficiency of the solar cell can be significantly enhanced by forming inorganic passivation layers (such as the first interface passivation layer and the second interface passivation layer) on both sides of the perovskite layer, or incorporating a dense barrier layer between the perovskite layer and the metal oxide hole transport layer. In Example 3, tin oxide was deposited using atomic layer deposition to form the electron transport layer, which can improve the open-circuit voltage of the solar cell to a certain extent as compared with the electron transport layer made of $C_{60}$ in Example 1, with the power conversion efficiency being comparable to that of Example 1. This indicates that the introduction of the second interface passivation layer enables the application of metal oxide electron transport materials in high-efficiency inverted solar cells, improving the electromagnetic transport performance of the metal oxide electron transport materials. In Example 5, dual-source co-evaporation of $C_{60}$ and PCBM can further enhance the open-circuit voltage, short-circuit current, fill factor, and power conversion efficiency of the solar cell to a certain extent.

In Example 2, the dense barrier layer of $AlO_x$ was formed between the SAM and the hole transport layer of NiO, which further improves the open-circuit voltage, short-circuit current, fill factor, and power conversion efficiency of the solar cell to a certain extent. The improvement in Example 2 is superior to that in Example 1, where the first interface passivation layer was formed on the hole transport layer. In Example 4, the dense barrier layer of $AlO_x$ was formed between the SAM and the hole transport layer of NiO, and $C_{60}$ and PCBM were formed using dual-source co-evaporation, which further enhance the open-circuit voltage, short-circuit current, fill factor, and power conversion efficiency of the solar cell to a certain extent. The improvement in Example 4 is also superior to that in Example 5, where the first interface passivation layer was formed on the hole transport layer.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

**Claims**

1.  A solar cell comprising:

    a first electrode and a second electrode;
    a perovskite layer disposed between the first electrode and the second electrode;
    a first interface passivation layer disposed between the perovskite layer and the first electrode; and
    a second interface passivation layer disposed between the perovskite layer and the second electrode;
    wherein a material of the first interface passivation layer and a material of the second interface passivation layer each comprise an inorganic material.

2.  The solar cell according to claim 1, wherein the material of the first interface passivation layer comprises one or more selected from the group consisting of aluminum oxide, silicon oxide, and magnesium oxide.

3.  The solar cell according to claim 1 or 2, wherein the material of the second interface passivation layer comprises one or more selected from the group consisting of aluminum oxide, silicon oxide, and magnesium oxide.

4.  The solar cell according to any one of claims 1 to 3, wherein a thickness of the first interface passivation layer is in a range from about 0.1 nm to about 50 nm.

5.  The solar cell according to any one of claims 1 to 4, wherein a thickness of the second interface passivation layer is in a range from about 0.1 nm to about 50 nm.

6.  The solar cell according to any one of claims 1 to 5, wherein the first interface passivation layer and the second interface passivation layer each completely cover the perovskite layer.

7.  The solar cell according to any one of claims 1 to 6, further comprising an electron transport layer, wherein the electron transport layer is disposed between the second electrode and the second interface passivation layer.

8.  The solar cell according to claim 7, wherein the electron transport layer comprises two or more materials selected from the group consisting of fullerene, a derivative of fullerene, graphene, and carbon nanotubes.

9.  The solar cell according to claim 7 or 8, wherein a thickness of the electron transport layer is in a range from about 0.1 nm to about 100 nm.

10. The solar cell according to claim 7, further comprising a substrate layer, wherein the substrate layer is disposed on a surface of the first electrode facing away from the perovskite layer;

    the electron transport layer is disposed on a surface of the second interface passivation layer facing away from the perovskite layer;
    the electron transport layer comprises one or more materials selected from the group consisting of zinc oxide, titanium oxide, tin oxide, and niobium oxide.

11. The solar cell according to claim 7 or 10, wherein a thickness of the electron transport layer is in a range from about 1 nm to about 100 nm.

12. The solar cell according to any one of claims 1 to 11 further comprising a hole transport layer, wherein the hole transport layer is disposed between the first electrode and the first interface passivation layer.

13. The solar cell according to claim 12, wherein the hole transport layer is disposed on a surface of the first interface passivation layer facing away from the perovskite layer;

the solar cell further comprises a substrate layer and a dense barrier layer, the dense barrier layer is disposed between the hole transport layer and the first electrode;
the substrate layer is disposed on a surface of the first electrode facing away from the perovskite layer;
the dense barrier layer is configured to prevent contact between the perovskite layer and the first electrode while allowing holes to be transported between the first electrode and the hole transport layer.

14. The solar cell according to claim 13, wherein the dense barrier layer comprises one or more materials selected from the group consisting of aluminum oxide, silicon oxide, and magnesium oxide.

15. The solar cell according to claim 13 or 14, wherein a thickness of the dense barrier layer is in a range from about 0.1 nm to about 5 nm.

16. The solar cell according to any one of claims 1 to 15 comprising a first cell and a second cell stacked on the first cell, wherein the first cell comprises the perovskite layer, the first interface passivation layer, and the second interface passivation layer; the second cell is any one of a perovskite cell, a silicon-based solar cell, a copper indium gallium selenide solar cell, or an organic thin-film solar cell.

17. A method for preparing a solar cell, comprising:

forming a first electrode on a substrate layer;
sequentially forming a first interface passivation layer, a perovskite layer, a second interface passivation layer, and a second electrode on a side of the first electrode facing away from the substrate layer;
wherein the perovskite layer is formed between the first electrode and the second electrode, the first interface passivation layer is formed between the first electrode and the perovskite layer, the second interface passivation layer is formed between the second electrode and the perovskite layer, and a material of the first interface passivation layer and a material of the second interface passivation layer each comprise an inorganic material.

18. The method according to claim 17, wherein the first interface passivation layer and the second interface passivation layer are independently deposited using one of following methods:
atomic layer deposition, evaporation deposition, magnetron sputtering, or plasma-enhanced chemical vapor deposition.

19. The method according to claim 17 or 18, wherein the solar cell further comprises an electron transport layer; the method further comprises:
before forming the second electrode on the second interface passivation layer, forming the electron transport layer on a surface of the second interface passivation layer facing away from the perovskite layer through evaporation deposition, wherein the electron transport layer comprises two or more materials selected from the group consisting of fullerene, a derivative of fullerene, graphene, and carbon nanotubes.

20. The method according to claim 19, wherein the evaporation deposition comprises at least one of thermal evaporation, electron beam evaporation, or close-space sublimation.

21. The method according to claim 19 or 20, wherein the electron transport layer is formed by co-evaporation of a plurality of sources; or
the electron transport layer is formed by evaporation of a single source of physically mixed materials.

22. The method according to claim 17 or 18, wherein the solar cell further comprises an electron transport layer; the method further comprises:
before forming the second electrode on the second interface passivation layer, depositing the electron transport layer on a surface of the second interface passivation layer facing away from the perovskite layer using one of following methods:

atomic layer deposition, reactive plasma deposition, magnetron sputtering, slot-die coating, blade coating, spray coating, or inkjet printing;

wherein the electron transport layer comprises one or more materials selected from the group consisting of zinc oxide, titanium oxide, tin oxide, and niobium oxide.

23. The method according to any one of claims 17 to 22, wherein the solar cell further comprises a hole transport layer and a dense barrier layer; the method further comprises:

before forming the first interface passivation layer on the first electrode, sequentially forming the dense barrier layer and the hole transport layer on the first electrode, wherein the dense barrier layer is configured to prevent contact between the perovskite layer and the first electrode while allowing holes to be transported between the first electrode and the hole transport layer.

24. A solar cell comprising:

a first electrode and a second electrode;
a perovskite layer disposed between the first electrode and the second electrode;
a hole transport layer disposed between the perovskite layer and the first electrode;
a dense barrier layer disposed between the first electrode and the perovskite layer, the dense barrier layer being configured to prevent contact between the perovskite layer and the first electrode while allowing holes to be transported between the first electrode and the hole transport layer.

25. The solar cell according to claim 24, wherein the dense barrier layer comprises one or more materials selected from the group consisting of aluminum oxide, silicon oxide, and magnesium oxide.

26. The solar cell according to claim 24 or 25, wherein a thickness of the dense barrier layer is in a range from about 0.1 nm to about 5 nm.

27. A method for preparing a solar cell comprising:

forming a first electrode on a substrate layer;
sequentially forming a dense barrier layer, a hole transport layer, a perovskite layer, and a second electrode on a side of the first electrode facing away from the substrate layer;
wherein the dense barrier layer is configured to prevent contact between the perovskite layer and the first electrode while allowing holes to be transported between the first electrode and the hole transport layer.

FIG. 1

FIG. 2

FIG. 3

FIG. 4

FIG. 5

## INTERNATIONAL SEARCH REPORT

| International application No. |
| --- |
| **PCT/CN2024/091701** |

| A. | CLASSIFICATION OF SUBJECT MATTER |
| --- | --- |

H10K30/88(2023.01)i; H10K30/40(2023.01)i; H10K30/50(2023.01)i; H10K71/00(2023.01)i

According to International Patent Classification (IPC) or to both national classification and IPC

| B. | FIELDS SEARCHED |
| --- | --- |

Minimum documentation searched (classification system followed by classification symbols)

IPC: H10K

Documentation searched other than minimum documentation to the extent that such documents are included in the fields searched

Electronic data base consulted during the international search (name of data base and, where practicable, search terms used)

CNTXT: CNABS; CNKI; VEN; USTXT; EPTXT; WOTXT: 钙钛矿, 钝化, 改性, 修饰, 界面, 阻挡, 阻隔, 隔离, 保护, 双侧, 双面, 两侧, 两面, 氧化硅, 氧化铝, 氧化镁, 自组织, perovskite, passivat+, modif+, interface, barrier, isolate+, protect+, double, two, second, side?, silicon oxide, aluminum oxide, magnesium oxide, Si+O+, Al+O+, MgO, SAM, +PACz

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | US 2019229285 A1 (EINDHOVEN UNIVERSITY OF TECHNOLOGY) 25 July 2019 (2019-07-25)<br>description, paragraphs [0002]-[0040], and figures 1-6B | 1-27 |
| X | CN 116801652 A (SHENZHEN HIKING PV TECHOLOGY CO., LTD.) 22 September 2023 (2023-09-22)<br>description, paragraphs [0002]-[0186], and figures 1-4 | 1-27 |
| Y | CN 116322091 A (NINGBO INSTITUTE OF MATERIAL TECHNOLOGY AND ENGINEERING, CHINESE ACADEMY OF SCIENCES) 23 June 2023 (2023-06-23)<br>description, paragraphs [0002]-[0104], and figures 1-2 | 1-27 |
| Y | CN 218735822 U (HANGZHOU MICROQUANTA SEMICONDUCTOR CO., LTD.) 24 March 2023 (2023-03-24)<br>description, paragraphs [0002]-[0100], and figures 1-3 | 1-27 |
| A | CN 104183697 A (CHANGZHOU UNIVERSITY) 03 December 2014 (2014-12-03)<br>entire document | 1-27 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **06 August 2024** | **14 September 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2024/091701** |

**C.** **DOCUMENTS CONSIDERED TO BE RELEVANT**

| Category* | Citation of document, with indication, where appropriate, of the relevant passages | Relevant to claim No. |
|---|---|---|
| A | CN 110289354 A (SHANGHAI JIAO TONG UNIVERSITY) 27 September 2019 (2019-09-27)<br>      entire document | 1-27 |

**INTERNATIONAL SEARCH REPORT**
Information on patent family members

International application No.

**PCT/CN2024/091701**

| Patent document cited in search report | | | Publication date (day/month/year) | Patent family member(s) | | | Publication date (day/month/year) |
|---|---|---|---|---|---|---|---|
| US | 2019229285 | A1 | 25 July 2019 | EP | 3482427 | A1 | 15 May 2019 |
| | | | | EP | 3482427 | B1 | 21 June 2023 |
| | | | | WO | 2018007586 | A1 | 11 January 2018 |
| | | | | JP | 2019521531 | A | 25 July 2019 |
| | | | | US | 11882711 | B2 | 23 January 2024 |
| | | | | JP | 2023171716 | A | 05 December 2023 |
| CN | 116801652 | A | 22 September 2023 | None | | | |
| CN | 116322091 | A | 23 June 2023 | None | | | |
| CN | 218735822 | U | 24 March 2023 | CN | 118042849 | A | 14 May 2024 |
| | | | | WO | 2024098655 | A1 | 16 May 2024 |
| CN | 104183697 | A | 03 December 2014 | CN | 104183697 | B | 11 January 2017 |
| CN | 110289354 | A | 27 September 2019 | None | | | |

Form PCT/ISA/210 (patent family annex) (July 2022)

# EP 4 665 124 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202410138459